# EUROPEAN PATENT APPLICATION

(11) **EP 4 293 703 A1**
(43) Date of publication of application: **20.12.2023**
(21) Application number: 22894762.8
(22) Date of filing: 15.11.2022
(51) Int. Cl.: H01J 49/02

(54) **ION SCREENING METHOD AND SYSTEM FOR MASS SPECTROMETER, HIGH-VOLTAGE PULSE CIRCUIT, AND SELECTION CIRCUIT**

(30) Priority: 18.11.2021 CN 202111370623; 18.11.2021 CN 202122831001 U
(71) Applicant: Autobio Labtec Instruments Co., Ltd., Zhengzhou, Henan 450016 (CN)
(72) Inventor: CAI, Keya, Zhengzhou, Henan 450016 (CN); LI, Xiangguang, Zhengzhou, Henan 450016 (CN); SHANG, Yuanhe, Zhengzhou, Henan 450016 (CN); HAN, Lele, Zhengzhou, Henan 450016 (CN); CHEN, Shichuang, Zhengzhou, Henan 450016 (CN); WU, Yunzhao, Zhengzhou, Henan 450016 (CN); ZHANG, Ruifeng, Zhengzhou, Henan 450016 (CN); LIU, Cong, Zhengzhou, Henan 450016 (CN)
(74) Representative: Kolster Oy Ab
(86) International application number: PCT/CN2022/131863
(87) International publication number: WO 2023/088228

(57) **Abstract**

An ion screening method and system for a mass spectrometer. The mass spectrometer is provided with a deflection conductor. The screening method comprises: before a laser synchronization pulse signal is output, connecting a first voltage signal to a deflection conductor to generate a deflection electric field for deflecting the flight direction of non-target ions; when the target ions fly out of an accelerating electric field, connecting a second voltage signal to the deflection conductor, such that target ions reach a detector; and when the target ions all pass through the deflection conductor, connecting the first voltage signal to the deflection conductor. According to the present application, the service life of the detector is prolonged, and interference of the non-target ions is avoided. A high-voltage pulse circuit and an ion selection circuit, comprising a circuit consisting of a first voltage source, a second voltage source, a pulse circuit, and an RC series circuit. A difference between voltages output by the first voltage source and the second voltage source is not less than a preset voltage difference; and a transistor switch is turned on and turned off to implement high-low level switching. According to the present application, a buffer duration of high-low level switching in a high-voltage pulse signal is shortened.

## Description

The present application claims priorities to Chinese Patent Application No. 202111370623.4, titled "METHOD AND SYSTEM FOR SELECTING IONS IN MASS SPECTROMETER", filed on November 18, 2021 and Chinese Patent Application No. 202122831001.9, titled "HIGH-VOLTAGE PULSE CIRCUIT AND CIRCUIT FOR SELECTING IONS", filed on November 18, 2021 with the China National Intellectual Property Administration, both of which are incorporated herein by reference in there entireties.

### FIELD

The present disclosure relates to the technical field of ion detection, and in particular to a method and a system for selecting ions method in a mass spectrometer, a high-voltage pulse circuit, and a circuit for selecting ions.

### BACKGROUND

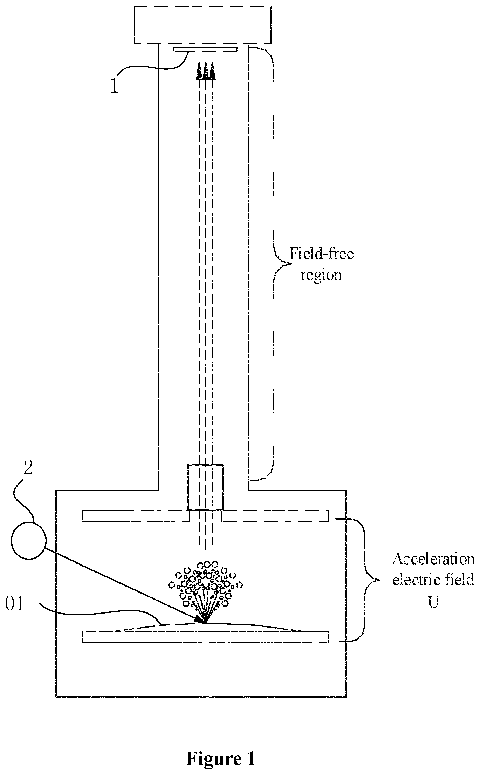

Reference is made to Figure 1, which is a schematic structural diagram of a conventional mass spectrometer. A laser source emits a laser pulse to excite a sample, so as to generate ions from the sample. The ions are accelerated in an accelerating field, then enter a field-free drift tube, and fly towards an ion detector at a constant speed. In practice, not all ions generated through the excitation are target ions required to be detected. The target ions, which are a target of dedicated detection and analysis, refer to only ions having molecular weights within a specific range. In conventional mass spectrometers, all ions generated by exciting the sample fly towards the ion detector and are eventually received by the ion detector. The ion detector can only receive and detect ions of a limited quantity, and would be unusable once a quantity of the detected ions reaches an upper limit. Hence, a large quantity of useless non-target ions among the ions received and detected by the ion detector shortens a service life of the ion detector. A solution of preventing the non-target ions generated from the sample from being received by the ion detector can prolong the service life of the ion detector greatly.

Pulse signals are electrical signals widely applied to various electronic and electrical devices. For example, a rectangular pulse signal may serve as a control signal for a relay switch. An ideal rectangular pulse signal has no delay when switching from a high voltage to a low voltage and switching reversely. In practice, it is incapable to implement such zero-delay during the above switching. At present, the delay during the above switching may be shortened to an almost negligible degree for low-voltage pulse signals, while it is still rather difficult to shorten the delay to a satisfactory degree for high-voltage pulse signals. Thereby, only limited precision can be achieved while using the high-voltage pulse signals for control, which restricts application of the high-voltage pulse signals.

### SUMMARY

An objective of embodiments of the present disclosure is providing a method and a system for selecting ions in a mass spectrometer, which reduces a quantity of non-target ions which reach a detector and hence prolongs a service life of the detector in the mass spectrometer. A high-voltage pulse circuit and a circuit for selecting ions are further provided, which shortens delay of rising edges and falling edges of a high-voltage pulse signal and thereby improves a control precision of the high-voltage pulse signal.

In order to address the above technical issues, a method for selecting ions in a mass spectrometer is provided according to an embodiment of the present disclosure. A deflection conductor is disposed at a side of an ion-flight path between an acceleration electric field and a detector in the mass spectrometer, and the method comprises: applying a first voltage to the deflection conductor to generate a deflection electric field at the deflection conductor, where ions are deflected to a trajectory not reaching the detector when flying through the deflection electric field; maintaining the first voltage applied to the deflection conductor to deflect non-target ions, among the ions, which fly out of the acceleration electric field, in response to detecting that a pulse synchronized with a laser is outputted; applying a second voltage to the deflection conductor to stop generating the deflection electric field and enable target ions, among the ions, to reach the detector, in response to the target ions flying out of the acceleration electric field; and applying the first voltage to the deflection conductor, in response to all of the target ions flying past the deflection conductor.

In an embodiment, the deflection conductor is at least one pair of conductor plates arranged at two sides of the ion-flight path, each of the at least one pair of conductor plates comprises a first conductor plate and a second conductor plate, and the first conductor plate is grounded. Applying the first voltage to the deflection conductor comprises: applying a high voltage which is greater than a grounding voltage to the second conductor to the second conductor plate, or applying a negative high voltage which is lower than a grounding voltage to the second conductor plate. Applying the second voltage to the deflection conductor comprises: applying a voltage equal to the grounding voltage to the second conductor plate.

In an embodiment, the deflection conductor is a focusing electrode arranged in the mass spectrometer or a metal tubular shell arranged in a field-free region of the mass spectrometer. Applying the first voltage to the deflection conductor comprises: applying a high voltage, which is opposite to the ions in electrical polarity, to the deflection conductor. Applying the second voltage to the deflection conductor comprises: applying a high voltage, which is identical the ions in electrical polarity, to the deflection conductor.

In an embodiment, the method further comprises: applying the first voltage and the second voltage alternately to the deflection conductor for multiple cycles, where in each of the multiple cycles, duration of applying the first voltage and duration of applying the second voltage is determined by a molecular weight of the non-target ions that are to be deflected and a molecular weight of the target ions that are not to be deflected.

A system for selecting ions in a mass spectrometer is further provided according to an embodiment of the present disclosure. The system comprises: a controller, of which an input terminal is connected to a laser source configured to output a laser pulse; and a circuit for selecting ions, where an output terminal of the circuit is connected to a deflection conductor disposed in the mass spectrometer, and an input terminal of the circuit is connected to the controller; where the controller is configured to control the circuit for selecting ions to output a voltage, which is switched between a first voltage and a second voltage, to the deflection conductor to implement any forgoing method for selecting ions in the mass spectrometer.

In an embodiment, the deflection conductor is at least one pair of conductor plates arranged at two sides of the ion-flight path, each of the at least one pair of conductor plates comprises a first conductor plate and a second conductor plate, and the first conductor plate is grounded. The second conductor plate is connected to an output terminal of the circuit for selecting ions, and the circuit for selecting ions comprises a high-voltage power source, a pulse circuit, and an RC series circuit. The pulse circuit comprises a voltage divider and a transistor that are connected in series. A terminal of the pulse circuit is connected to an output terminal of the high-voltage power source, and another terminal of the pulse circuit is grounded. A node at which the voltage divider and the transistor are connected serves as the output terminal of the circuit for selecting ions. A first terminal of the RC series circuit is connected to the output terminal of the circuit for selecting ions, and a second terminal of the RC series circuit is grounded. The controller is connected to the control terminal of the transistor, and the controller is configured to switch the transistor between on and off.

In an embodiment, a first terminal of the voltage divider is connected to the high-voltage power source, a second terminal of the voltage divider is connected to a first terminal of the transistor, and a second terminal of the transistor is grounded. In response to the controller outputting an electrical level, the first terminal and the second terminal of the transistor are electrically disconnected. In response to the controller outputting another electrical level higher that the electrical level, the first terminal and the second terminal of the transistor are electrically connected.

In an embodiment, a first terminal of the transistor is connected to the high-voltage power source, a second terminal of the transistor is connected to a first terminal of the voltage divider, and a second terminal of the voltage divider is grounded. In response to the controller outputting an electrical level, the first terminal and the second terminal of the transistor are electrically disconnected. In response to the controller outputting another electrical level higher that the electrical level, the first terminal and the second terminal of the transistor are electrically connected.

In an embodiment, the circuit for selecting ions further comprises an RC parallel circuit, and the control terminal of the transistor is connected to the controller via the RC parallel circuit.

The method for selecting ions in the mass spectrometer is provided according to embodiments of the present disclosure. The deflection conductor is disposed at the side of the ion-flight path between the acceleration electric field and the detector in the mass spectrometer. The method comprises: applying the first voltage to the deflection conductor to generate the deflection electric field at the deflection conductor, where the ions are deflected to the trajectory not reaching the detector when flying through the deflection electric field; maintaining the first voltage applied to the deflection conductor to deflect the non-target ions which fly out of the acceleration electric field, in response to detecting that the pulse synchronized with a laser is outputted; applying the second voltage to the deflection conductor to stop generating the deflection electric field and enable the target ions to reach the detector, in response to the target ions flying out of the acceleration electric field; and applying the first voltage to the deflection conductor, in response to all of the target ions flying past the deflection conductor.

Herein utilized is a principle that ions having different molecular weights pass through the field-free region of the mass spectrometer at different times when fly towards the detector. The first voltage is applied to the deflection conductor in the mass spectrometer before the source of laser pulses is activated, so that the deflection electric field generated by the deflection conductor is capable to deflect the non-target ions as soon as the source of laser pulses is activated. The second voltage is applied to the deflection conductor when the target ions start to fly, and hence the deflection conductor no longer generates the electric field which deflects the target ions. After all of the target ions have flown past the field-free region, the first voltage is applied again to the deflection conductor. Hence, it is ensured that the electric field generated by the deflection conductor is capable to deflect both ions having the molecular weight greater that of the target ions and ions having the molecular weight smaller that of the target ions and prevent these ions from reaching the detector. The service life of the detector can be prolonged. Moreover, the detector presents a result of detecting only the target ions, which avoids interference of the non-target ions on the detection of the target ions.

A system for selecting ions in a mass spectrometer is further provided according to an embodiment of the present disclosure, and also has the above beneficial effects.

A high-voltage pulse circuit is further provided according to an embodiment of the present disclosure. The high-voltage pulse circuit comprises a first voltage source, a second voltage source, a pulse circuit, and an RC series circuit. A difference between a voltage outputted by the first voltage source and a voltage outputted by the second voltage source is not less than a preset voltage. The pulse circuit comprises a voltage divider and a transistor that are connected in series. A terminal of the pulse circuit is connected to the first voltage source, and another terminal of the pulse circuit is connected to the second voltage source. A node at which the voltage divider and the transistor are connected serves as an output terminal of the high-voltage pulse circuit. A first terminal of the RC series circuit is connected to the output terminal of the high-voltage pulse circuit, and a second terminal of the RC series circuit is connected to the second voltage source. The transistor is configured to switch between on and off according to a switch controlling signal received by a control terminal of the transistor.

In an embodiment, a first terminal of the voltage divider is connected to the first voltage source, a second terminal of the voltage divider is connected to a first terminal of the transistor, and a second terminal of the transistor is connected to the second voltage source. The first terminal and the second terminal of the transistor are electrically connected in response to the switch controlling signal is at an electrical level, and are electrically disconnected in response to the switch controlling signal is at another electrical level lower than the electrical level.

In an embodiment, a first terminal of the transistor is connected to the first voltage source, a second terminal of the transistor is connected to a first terminal of the voltage divider, and a second terminal of the voltage divider is connected to the second voltage source. The first terminal and the second terminal of the transistor are electrically connected in response to the switch controlling signal is at an electrical level, and are electrically disconnected in response to the switch controlling signal is at another electrical level lower than the electrical level.

In an embodiment, the first voltage source is a power source that outputs a high voltage, and the voltage outputted by the second voltage source is a grounding voltage. Alternatively, the first voltage source is a power source that outputs a high voltage, and the second voltage source is a power source that outputs a negative high voltage. Alternatively, the voltage outputted by the first voltage source is a grounding voltage, and the second voltage source is a power source that outputs a negative high voltage.

In an embodiment, the high-voltage pulse circuit further comprises an RC parallel circuit connected to the control terminal of the transistor. The control terminal of the transistor is configured to receive the switch controlling signal via the RC parallel circuit.

A circuit for selecting ions, which is applicable to a mass spectrometer comprising a conductor for deflecting non-target ions, is further provided. The circuit for selecting ions comprises a controller and any foregoing high-voltage pulse circuit. The output terminal of the high-voltage pulse circuit is connected to the conductor, and an output terminal of the controller is connected to the control terminal of the transistor in the high-voltage pulse circuit. The controller is configured to output the switch controlling signal to the high-voltage pulse circuit, and switch the switch controlling signal between two different levels to enable a high-voltage pulse signal outputted by the high-voltage pulse circuit to switch between two different voltages.

Herein the high-voltage pulse circuit comprises the first voltage source, the second voltage source, the pulse circuit, and the RC series circuit. The difference between the voltage outputted by the first voltage source and the voltage outputted by the second voltage source is not less than the preset difference. The pulse circuit comprises the voltage divider and the transistor that are connected in series. The terminal of the pulse circuit is connected to the first voltage source, and the other terminal of the pulse circuit is connected to the second voltage source. The node at which the voltage divider and the transistor are connected serves as the output terminal of the high-voltage pulse circuit. The first terminal of the RC series circuit is connected to the output terminal of the high-voltage pulse circuit, and the second terminal of the RC series circuit is connected to the second voltage source. The transistor is configured to switch between on and off according to the switch controlling signal received by the control terminal of the transistor.

Herein the transistor and the voltage divider are connected in series and serve as the pulse circuit between the first voltage source and the second voltage source. The transistor is switched between on and off, such that the high-voltage pulse circuit generates the high-voltage pulse at the node between the transistor and the voltage divider. The voltage outputted by the first voltage source serves as a high voltage of the high-voltage pulse signal and the voltage outputted by the second voltage source serves as a low voltage of the high-voltage pulse signal. The transistor switch and the voltage divider constitute an equivalent of an RC circuit, and introduce a delay of switching between the high voltage and the low voltage. Herein the RC series circuit is further connected in parallel between the output terminal of the high-voltage pulse circuit and the second voltage source. The RC series circuit is capable to charge and discharge a junction capacitor in the transistor switch, and hence turning on/off the transistor switch based on the control signal consumes less time, which reduces the delay of switching between the high voltage and the low voltage in the high-voltage pulse signal. Therefore, the outputted high-voltage pulse signal can be switched between the high voltage and the low voltage in a scale of several nanoseconds, which facilitates wide application of high-voltage pulse signals.

A circuit for selecting ions is further provided according to an embodiment of the present disclosure, and also has the above beneficial effects.

### BRIEF DESCRIPTION OF THE DRAWINGS

For clearer illustration of the technical solutions according to embodiments of the present disclosure or conventional techniques, hereinafter briefly described are the drawings to be applied in embodiments of the present disclosure or conventional techniques. Apparently, the drawings in the following descriptions are only some embodiments of the present disclosure, and other drawings may be obtained by those skilled in the art based on the provided drawings without creative efforts.
Figure 1 is a schematic structural diagram of a conventional mass spectrometer.
Figure 2 is a flowchart of a method for selecting ions in a mass spectrometer according to an embodiment of the present disclosure.
Figure 3 is a schematic structural diagram of a mass spectrometer according to an embodiment of the present disclosure.
Figure 4 shows a mass spectrum obtained by a detector without selecting between target ions and non-target ions.
Figure 5 shows a mass spectrum obtained by a detector through selecting target ions having molecular weights within one range.
Figure 6 shows a mass spectrum obtained by a detector through selecting target ions having molecular weights within multiple separate ranges.
Figure 7 is a schematic structural diagram of a circuit for selecting ions according to an embodiment of the present disclosure.
Figure 8 is a schematic structural diagram of a circuit for selecting ions according to another embodiment of the present disclosure.
Figure 9 is a schematic structural diagram of a high-voltage pulse circuit according to an embodiment of the present disclosure.
Figure 10 is a schematic structural diagram of a high-voltage pulse circuit according to another embodiment of the present disclosure.

### DETAILED DESCRIPTION OF EMBODIMENTS

Reference is made to Figure 1. In a mass spectrometer, a pulsed laser emitted by a laser source 2a excites a sample 01, which is a source of ions, to generate ions having different molecular weights. The ions with different molecular weights are accelerated to different speeds in an acceleration electric field U, where ions with a smaller molecular weight are accelerated to a greater speed while those with a larger molecular weight are accelerated to a smaller speed. Accordingly, when flying toward a detector 1, the ions with the smaller molecular weight leave the acceleration electric field U and enter a field-free region earlier, while those with the larger molecular weight leave the acceleration electric field U and enter the field-free region later.

Generally, during actual ion detection, only target ions having the molecular weight within a specific range are required to be detected, and ions having other molecular weights are called non-target ions. The non-target ions, which reach and are detected by the detector 1, not only shorten a service life of the detector 1 but also blur a result of detecting the target ions.

The difference in mass between the target ions and the non-target ions leads to the different in time at which the target ions and the non-target ions pass the field-free region, which is utilized herein for selection between the target ions and non-target ions. The non-target ions are prevented from flying toward the detector when passing through the field-free region. Thereby, the non-target ions cannot reach the detector 1, and only the target ions reach the detector 1 eventually for detection, which facilitate prolonging the service life of the detector and improving distinctness of a result of detection.

For better understanding of those skilled in the art, hereinafter technical solutions in embodiments of the present disclosure are described clearly and completely in conjunction with the drawings in embodiments of the present closure. Apparently, the described embodiments are only some rather than all of the embodiments of the present disclosure. Any other embodiments obtained based on the embodiments of the present disclosure by those skilled in the art without any creative effort fall within the scope of protection of the present disclosure.

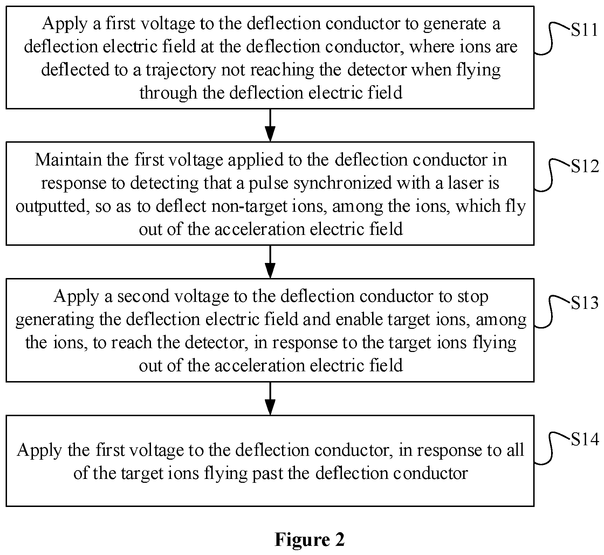

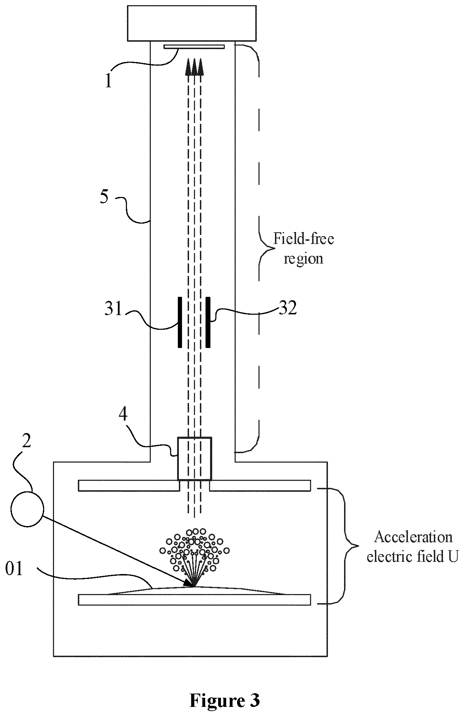

Reference is made to Figures 2 and 3. Figure 2 is a flowchart of a method for selecting ions in a mass spectrometer according to an embodiment of the present disclosure. Figure 3 is a schematic structural diagram of a mass spectrometer according to an embodiment of the present disclosure. Herein a deflection conductor is disposed at a side of an ion-flight path, which is between an acceleration electric field and a detector in the mass spectrometer, in order to implement a method for selecting ions in the mass spectrometer. The mass spectrometer as shown in Figure 3 is taken as an example. The deflection conductor may be a flat plate arranged in the field-free region. On such basis, the method for selecting ions in the mass spectrometer comprises following steps S11 to S14.

In step S11, a first voltage is applied to the deflection conductor to generate a deflection electric field at the deflection conductor, where ions are deflected to a trajectory not reaching the detector when flying through the deflection electric field.

The ions flying in the field-free region should follow a straight trajectory, that is, should fly along a direction from pointing from an exit of the acceleration electric field U to the detector 1, as shown in Figure 3. Due to an absence of external forces, a speed and a flying direction of the ions should keep constant in the field free region. An electric field would be generated around the deflection conductor as soon as the first voltage is applied to the deflection conductor. It is appreciated that the ions would be deflected to another trajectory under the electric field when flying through a spatial region occupied by the electric field, and thereby cannot reach the detector 1.

In step S12, the first voltage applied to the deflection conductor is maintained in response to detecting that a pulse synchronized with a laser is outputted, so as to deflect non-target ions, among the ions, which fly out of the acceleration electric field.

The pulse synchronized with a laser refers to a signal for activating the laser source 2 to emit a laser pulse to the sample 01. Generally, the first voltage is required to be applied to the deflection conductor when the laser synchronizing pulse starts to be outputted. After detecting the output of the laser synchronizing pulse, it is difficult to apply the first voltage to the deflection conductor immediately, which results in a delay of a time instant at which the first voltage starts to be applied to the deflection conductor with respect to a time instant at which the laser synchronizing pulse starts to be outputted. During such delay, some of the non-target ions may be generated from the excitation and reach the detector. Given the above issue, herein the first voltage is applied to the deflection conductor before the laser synchronizing pulse activates the laser source 2, so as to improve precision of removing the non-target ions. Thereby, the deflection conductor is capable to deflect the non-target ions as long as the non-target ions are generated, and hence the non-target ion cannot reach the detector 1.

In addition, amplitude of the first voltage should meet a certain requirement in order to ensure that strength of the electric field generated by the deflection conductor can exert a sufficient deflection force on the non-target ions. The first voltage is preferable to be a high voltage.

In step S13, a second voltage is applied to the deflection conductor to stop generating the deflection electric field and enable target ions, among the ions, to reach the detector, in response to the target ions flying out of the acceleration electric field.

A specific form of the second voltage depends strongly on a type of the deflection conductor.

In an embodiment, the deflection conductor may be at least one pair of conductor plates arranged at two sides of the ion-flight path. Each pair of conductor plates comprises a first conductor plate and a second conductor plate, and the first conductor plate is grounded. Applying the first voltage to the deflection conductor comprises a following step. A high voltage which is greater than a grounding voltage is applied to the second conductor to the second conductor plate, or a negative high voltage which is lower than a grounding voltage is applied to the second conductor plate. Applying the second voltage to the deflection conductor comprises a following step. A voltage equal to the grounding voltage is applied to the second conductor plate.

As shown in Figure 3, the deflection conductor is implemented as a pair of conductor plates. The first conductor plate 31 is grounded, and a high voltage is applied to the second conductor plate 32, so as to form the deflection electric field between the first conductor plate 31 and the second conductor plate 32. Thereby, the non-target ions with charges are deflected under the deflection electric field when flying between the first conductor plate 31 and the second conductor plate 32.

On such basis, it is appreciated that the electric field is capable to deflect the target ions, and hence should not be generated when the target ions enter a region between the first conductor plate 31 and the second conductor plate 32. At such time, the grounding voltage applied to the second conductor plate 32 may be utilized such that there is no electric field between the first conductor plate 31 and the second conductor plate 32. The target ions would not be deflected when flying through the region between the first conductor plate 31 and the second conductor plate 32, and hence can reach the detector 1.

In practice, it is not necessary to configure the deflection conductor as a pair of conductor plates at two sides of the ion-flight path. The deflection conductor may alternatively be implemented as a single conductor component. In such case, the non-target ions can also be deflected when a high voltage is applied to the conductor component to form an electric field at the conductor component. When the target ions pass, the high voltage is switched to a grounding voltage to eliminate the electric field around the conductor component, so that the target ions can reach the detector 1.

In another embodiment, the deflection conductor may be a focusing electrode 4 arranged in the mass spectrometer, or may be a metal tubular shell 5 in a field-free region of the mass spectrometer. Applying the first voltage to the deflection conductor comprises a following step. A high voltage, which is opposite to the ions in electrical polarity, is applied to the deflection conductor. Applying the second voltage to the deflection conductor comprises a following step. A high voltage, which is identical the ions in electrical polarity, is applied to the deflection conductor.

The focusing electrode 4 is taken as an example of the deflection conductor implemented. The focusing electrode 4 in the mass spectrometer is a metal tube arranged at an exit of the acceleration electric field U. In conventional mass spectrometers, it cannot be ensure that all ions generated by exciting the sample 01 fly towards the detector 1 after being accelerated in the acceleration electric field U. Rather, some ions fly with a certain deviation angle. Therefore, it is necessary to arrange the focusing electrode 4 in the mass spectrometer. In a case that all ions generated through the laser exciting the ion-source sample 01 are positive ions, a positive voltage is applied to the focusing electrode 4, such that an electric field of which field lines converge at a central axis of the metal tube is generated in the focusing electrode 4. When the ions fly along a direction deviating from the central axis of the focusing electrode 4, their trajectory is adjusted toward the central axis of the focusing electrode 4 under the electric field, such that that a final trajectory of the ions almost coincides with a straight line at which the central axis of the focusing electrode 4 is disposed. Similarly, in a case that all ions generate through the excitation are negative ions, a negative voltage is applied to the focusing electrode 4, such that field lines of the electric field generated in the focusing electrode 4 diverge from the central axis to a wall of the tube.

It is noted that the target ions and the non-target ions, which are generated through laser excitation on the same sample and fly from the acceleration electric field, have the same electrical polarity.

Accordingly, herein different voltages are applied to the focusing electrode 4 when the target ions pass through the focusing electrode 4 and when the non-target ions pass through the focusing electrode 4, so as to implement selection between the target ions and the non-target ions.

It is taken as an example that both the target ions and the non-target ions are positive ions. When the non-target ions pass through the focusing electrode 4, the first voltage which is a negative voltage lower than 0V is applied to the focusing electrode, such that the focusing electrode 4 attracts the non-target ions. Hence, a trajectory of the non-target ions deviates from the central axis towards the wall of focusing electrode 4, and the non-target ions cannot reach the detector 1.

When the target ions pass through the tube of the focusing electrode 4, the second voltage which is a positive voltage higher than 0V is applied to the focusing electrode 4, such that the focusing electrode 4 repels the target ions. Hence, a trajectory of the target ions stays close to the central axis of the focusing electrode 4, and the target ions can reaching the detector 1 more easily.

Similarly, in a case that both the target ions and the non-target ions are negative ions, the first voltage is a positive voltage higher than 0V, and the second voltage is a negative voltage lower than 0V

The deflection conductor implemented as the metal tubular shell 5 in the field-free region of the mass spectrometer is similar to that implemented as the focusing electrode 4 in a manner and a principle of operation. That is, the first voltage is opposite to the ions in electrical polarity, and the second voltage is identical to the ions in electrical polarity. Details are not repeated herein.

In step S14, the first voltage is applied to the deflection conductor, in response to all of the target ions flying past the deflection conductor.

Generally, there are non-target ions greater than the target ions in molecular weight and non-target ions smaller than the target ions in molecular weight, among the ions generated through exciting the sample 01. It is appreciated that, the non-target ions greater than the target ions in molecular weight fly slower than the target ions. Therefore, some non-target ions greater than the target ions in molecular weight are still flying towards the detector 1 when the target ions have been reached the detector 1. In order to prevent the non-target ions from reaching the detector 1 as much as possible, the first voltage may be further applied to the deflection conductor when all of the target ions have passed in the field-free region, so that the non-target ions greater than the target ions in molecular weight are deflected. Finally, only the target ions can reach the detector 1.

In addition, molecular weights of the target ions required to be detected may be distributed in multiple molecular-weight ranges which are discontinuous. For example, there are multiple molecular-weight ranges (0, a1], (a1, a2], (a2, a3], (a3, a4], and (a4, a5], ions having molecular weights within two ranges (a1, a2] and (a3, a4] are target ions, and ions having molecular weights within three molecular-weight ranges (0, a1], (a2, a3], and (a4, a5] are non-target ions. During selecting the ions, the first voltage and the second voltage are alternately applied to the deflection conductor for multiple cycles. Duration of applying the first voltage and duration of applying the second voltage in each cycle depend on the molecular weight of the non-target ions required to be deflected and the molecular weight of the target ions not required to be deflected. The first voltage is applied to the deflection conductor when the non-target ions having molecular weights within three molecular-weight ranges (0, a1], (a2, a3], and (a4, a5] fly through the field-free region. The second voltage is applied to the deflection conductor when target ions having molecular weights within two molecular-weight ranges (a1, a2] and (a3, a4] pass.

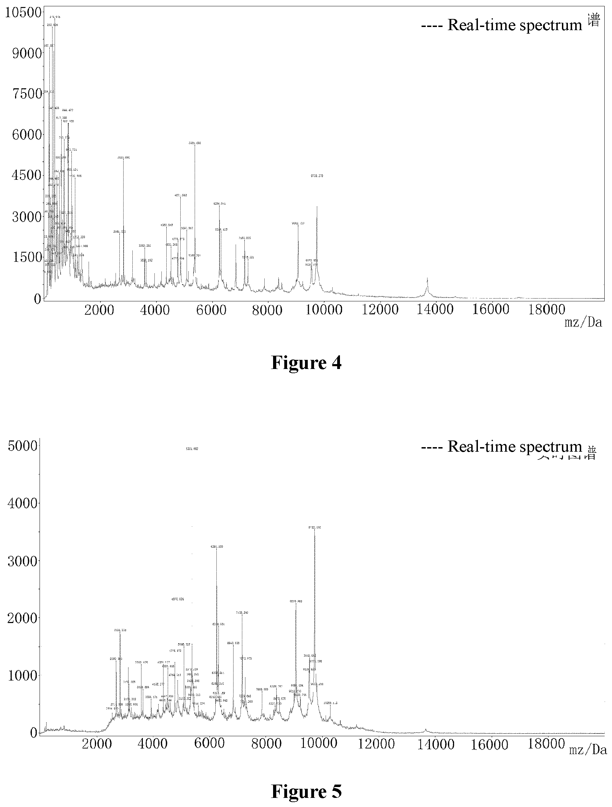

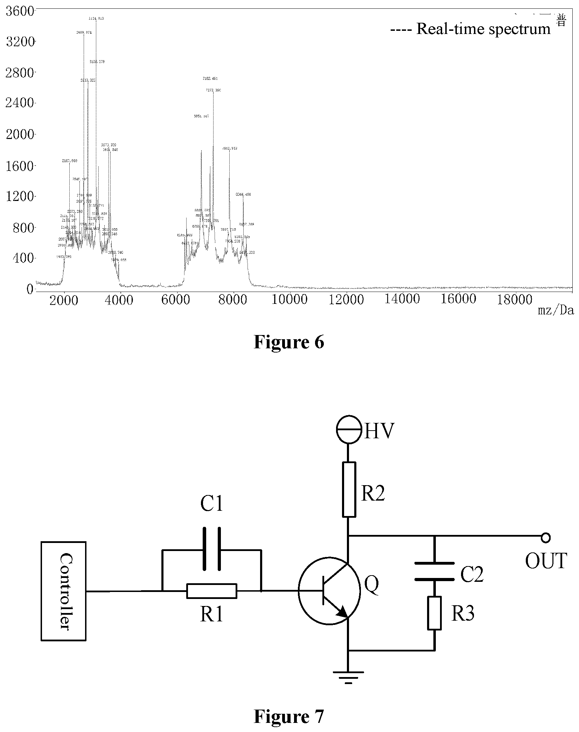

Reference is made to Figure 4 to Figure 6. Figure 4 shows a mass spectrum obtained by the detector without selecting between target ions and non-target ions. Figure 5 shows a mass spectrum obtained by the detector through selecting target ions having molecular weights within one range. Figure 6 shows a mass spectrum obtained by the detector through selecting target ions having molecular weights within multiple ranges. Comparison between Figure 4 and Figure 5 shows that spectrum peaks of the mass spectrum in Figure 4 comprises a matrix peak containing a large number of peaks corresponding to small molecular weights, which reduces the service life of the detector. Moreover, the peaks due to matrix molecules having small molecular weights are noise peaks, which reduce a signal-to-noise ratio of the mass spectrum and make operations of devices more complex. As shown in Figure 5, target ions having molecular weights within one preset molecular-weight range reach the detector, and the non-target ions having molecular weights out of such range are deflected and cannot reach the detector. Figure 6 shows a mass spectrum obtained by the detector through selecting target ions having molecular weights within two preset molecular-weight ranges. Only target ions with molecular weights within the target molecular-weight ranges are selected and reach the detector, and useless non-target ions are removed through the selection. Thereby, wear on the detector is reduced, and the service life of the detector is prolonged. Moreover, a noise in the mass spectrum is reduced, and the signal-to-noise ratio is greatly improved. Accordingly, it is only necessary to analyze and process the mass spectrum of ions having molecular weights within the target molecular-weight range, which simplify subsequent operation and improve efficiency of devices.

In summary, herein the deflection conductor is arranged at the field-free region in the mass spectrometer. The voltage enabling the deflection conductor to generate the deflection electric field is applied to the deflection conductor before the laser source is activated, so that all non-target ions that enter the field-free region first can be deflected and cannot to reach the detector. The voltage applied to the deflection conductor is switched when the target ions enter such field-free region, so that the target ions are not deflected by the deflection conductor. In addition, the voltage applied to the deflection conductor is switched again when all of the target ions have reached the detector, so that the non-target ions greater than the target ions in molecular weight are deflected by the deflection conductor. Thereby, the non-target ions is deflected to the most extent, and a quantity of the non-target ions reaching the detector is minimized, which slows down the wear on the detector and prolongs the service life of the detector.

A system for selecting ions in a mass spectrometer is further provided according to an embodiment of the present disclosure. The system comprises a controller and a circuit for selecting ions.

An input terminal of the controller is connected to a laser source configured to output a laser pulse.

An output terminal of the circuit is connected to a deflection conductor disposed in the mass spectrometer, and an input terminal of the circuit is connected to the controller.

The controller is configured to control the circuit for selecting ions to output a voltage, which is switched between a first voltage and a second voltage, to the deflection conductor to implement any forgoing method for selecting ions in the mass spectrometer.

According to the method for selecting ions in the mass spectrometer, the voltage applied to the deflection conductor is switched between two different constant voltages, so that the deflection conductor can select between the target ions and the non-target ions. Hence, the voltage applied to the deflection conductor may be regarded as square-wave pulse(s), and the circuit for selecting ions may adopt a structure for outputting square-wave pulses in practice. Generally, a voltage difference between a high voltage and a low voltage in the square-wave pulses should be no less than a certain value, in order to meet a requirement on the electric field which is generated by the deflection conductor for deflecting the non-target ions. That is, a pulse voltage signal outputted by the circuit for selecting ions is required to be high-voltage pulses.

Theoretically, a square-wave pulse signal switches instantaneously between a high voltage and a low voltage at rising edges and at falling edges. In practice, both the rising edge and the switch at the falling edge is subject to a delay, especially for the high-voltage pulses in which there is a large voltage difference between the high voltage and the low voltage. In the high-voltage pulses, it is difficult to implement fast rises and fast falls in the voltage when switching between the high voltage and the low voltage. A temporal difference between a time instance at which the target ions fly through the mass spectrometer and that at which the non-target ions fly through the mass spectrometer is rather short, and substantially in an order of several nanoseconds. Therefore, the fast rises and the fast falls between the high voltage and the low voltage are necessary when the circuit for selecting ions switches between outputting one voltage and outputting another voltage, such that accurate selection between the non-target ions and the target ions can be achieved.

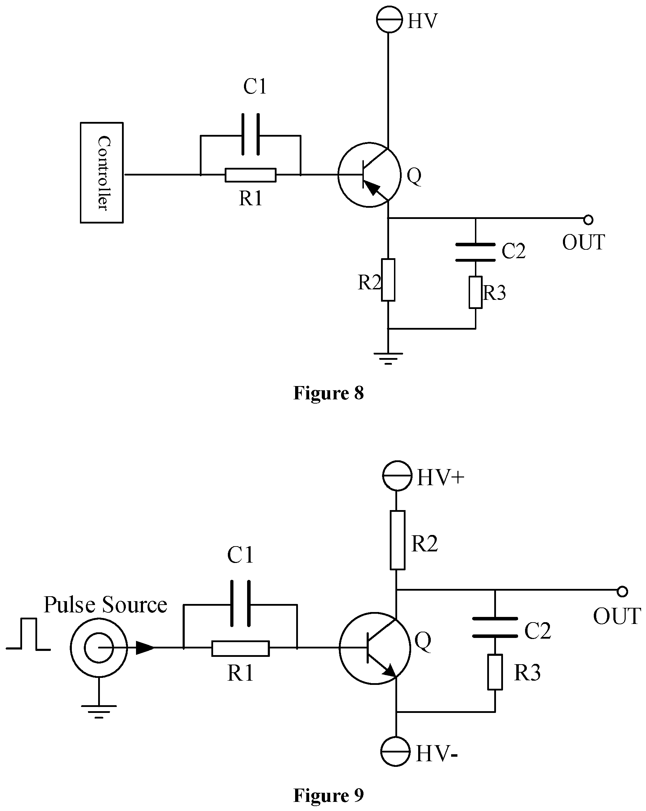

It is taken as an example that the deflection conductor is at least one pair of conductor plates arranged at two sides of the ion-flight path, each pair of conductor plates comprises a first conductor plate and a second conductor plate, the first conductor plate is grounded, and the second conductor plate is connected to the circuit for selecting ions. Reference is made to Figure 7 and Figure 8. Figure 7 is a circuit diagram of a circuit for selecting ions according to an embodiment of the present disclosure. Figure 8 is a circuit diagram of a circuit for selecting ions according to another embodiment of the present disclosure.

In an embodiment, the circuit for selecting ions may comprise a power source HV which outputs a high voltage, a pulse circuit, and an RC series circuit. As shown in Figure 7 and Figure 8, the RC series circuit comprises a capacitor C2 and a resistor R3 which are connected in series and have high-voltage resistance. The resistance R3 is subject to a large power, and hence its resistance is less than that of a voltage divider R2.

The pulse circuit comprises the voltage divider R2 and a transistor Q. A terminal of the pulse circuit is connected to an output terminal of the power source HV, and another terminal of the pulse circuit is grounded. A node at which the voltage divider R2 and the transistor Q are connected serves as an output terminal OUT of the circuit for selecting ions. A terminal of the RC series circuit is connected to the output terminal OUT, and another terminal of the RC series circuit is grounded. The controller is connected to a control terminal of the transistor Q and is configured to switch the transistor between on and off.

In an embodiment, an RC parallel circuit may be arranged between the controller and the control terminal of the transistor Q. The RC parallel circuit may comprise a resistor R1 and a capacitor C1 which are connected in parallel.

Herein output of the high-voltage pulses are mainly implemented through the pulse circuit comprising the voltage divider R2 and the transistor Q, where the terminal of the pulse circuit is connected to the output terminal of the high-voltage power source HV, and the other terminal of the pulse circuit is grounded. In addition, the control terminal of the transistor Q is connected to the output terminal of the controller via the RC parallel circuit, so that the controller switches the transistor Q between on and off through outputting a control signal. Whether a voltage at the node between the transistor Q and the voltage divider R2 is equal to the grounding voltage or the voltage outputted by the high-voltage power source HV depends on whether the transistor Q is switched on or switched off. Thereby, the voltage outputted by the pulse circuit is switched between the high voltage and the grounding voltage.

The pulse circuit is formed by the voltage divider R2 and the transistor Q. The voltage divider R2 may be a voltage dividing resistor or another voltage dividing component having certain resistance, and the transistor Q may be a semiconductor switch such as a triode, a MOS transistor, or the like, which is not limited in the present disclosure.

As mentioned above, the controller can switch the transistor Q between on or off. Due to basic operation principles of the transistor Q, the control signal used by the controller for controlling the transistor Q may be a pulse signal switching between a high level and a low level. Unlike the high-voltage pulse signal applied to the deflection conductor, only a low-voltage pulse signal is required to be outputted by the controller for the control terminal of transistor Q.

In addition, the pulse circuit comprising the voltage divider R2 and the transistor Q may be regarded as another RC series circuit. Since the transistor Q are similar a capacitor in processes of charging and discharging, a junction capacitor of the transistor Q and the voltage divider R2 form an equivalent of a RC series circuit. The junction capacitor of the transistor Q introduces a delay when switching on/off the transistor Q, and hence rising edges and falling edges of the finally outputted pulse signal is elongated.

Herein the RC series circuit is connected in parallel with a branch between the output terminal OUT and the ground in the circuit for selecting ions, in order to shorten the delay at the rising edges and the falling edges when the output of the circuit for selecting ions switches between the high voltage and the low voltage.

During changes in the high-voltage pulse signal, the RC series circuit comprising the high-voltage capacitor C2 and the high-voltage resistor R3 forms a path of charge/discharge and performs filtering. The capacitor C2 in the RC series circuit charges the transistor Q when the transistor Q is switched on, and discharges the transistor Q when the transistor Q is switched off. Hence, the delays at the rising edges and the falling edges of the outputted high-voltage pulses are shortened, and rapid switch between the high voltage and the low voltage is achieved. The rapid rises and falls in the outputted high-voltage pulse signal is quite short and in an order of several nanoseconds, which ensures precise switching between the high voltage and the low voltage. Moreover, the new RC circuit forms a filter which can remove high-order harmonics, and hence a waveform of the high-voltage pulses is regularized.

In addition, the controller is connected to the control terminal of the transistor Q via the RC parallel circuit. Since the capacitor C1 in the RC parallel circuit is capable of charging and discharging, switching the transistor Q between on or off consumes less time under control of the switch controlling signal.

In the high-voltage pulses outputted by the circuit for selecting ions, the delays at the rising edges and the falling edges can be shortened to several nanometers during switching between the high voltage and the low voltage. Since the delays at the rising edges and the falling edges are greatly shortened, the circuit for selecting ions can improve control precision of various control systems when being applied to these systems.

Elements in the pulse circuit may be connected in different configurations.

Reference is made to Figure 7. In an optional embodiment, the pulse circuit may be configured as follows. A first terminal of the voltage divider R2 is connected to the power source HV which outputs a high voltage, a second terminal of the voltage divider R2 is connected to a first terminal of the transistor Q, a second terminal of the transistor Q is grounded, and a control terminal of the transistor Q is connected to the controller via the RC parallel circuit. In response to the controller outputting a high level, the first terminal and the second terminal of the transistor Q are electrically connected. In response to the controller outputting a low level, the first terminal and the second terminal of the transistor Q are electrically disconnected.

Reference is made to Figure 7. The first terminal of the transistor Q is connected to the output terminal of the power source HV via the voltage divider R2, and the second terminal of the transistor Q is grounded. Hence, the RC series circuit is connected in parallel with the transistor Q. It is taken as an example that the transistor Q in Figure 7 is an NPN transistor. When the controller outputs the low level to a base of the transistor Q via the RC parallel circuit, a collector and an emitter of the transistor Q are electrically disconnected from each other. The collector of the transistor Q is connected to the voltage divider R2, and serves as the output terminal of the pulse circuit. In such case, the output terminal of the pulse circuit outputs the high voltage. When the controller outputs a high level to the base of the transistor Q, the collector and the emitter of the transistor Q are electrically connected to each other. In such case, the collector of the transistor Q is connected to the power source HV via the voltage divider R2, serves as the output terminal of the pulse circuit, and outputs a grounding voltage, i.e., 0V Thereby, a voltage outputted by the circuit for selecting ions switches between the high-voltage and the grounding voltage.

Reference is made to Figure 8. In another optional embodiment, the pulse circuit may be configured as follows. A first terminal of the transistor Q is connected to the power source HV which outputs a high voltage, a second terminal of the transistor Q is connected to a first terminal of the voltage divider R2, a control terminal of the transistor Q is connected to the controller via the RC parallel circuit, and a second terminal of the voltage divider R2 is grounded. In response to the controller outputting a low level, the first terminal and the second terminal of the transistor Q are electrically connected. In response to the controller outputting a high level, the first terminal and the second terminal of the transistor Q are electrically disconnected.

Reference is made to Figure 8. It is taken as an example that the transistor Q is a PNP transistor. The terminal of the transistor Q connected to the voltage divider R2 is as an emitter of the transistor Q. That is, the voltage at the emitter of the transistor Q serves as a voltage outputted by the pulse circuit. The RC series circuit is connected in parallel the voltage divider R2. Similar to principles in Figure 7, when the controller outputs a high level to the base of the transistor Q via the RC parallel circuit, the collector and the emitter of the transistor Q are disconnected from each other. In such case, the emitter of the transistor Q is connected to a grounding terminal via the voltage divider R2, and the voltage outputted by the pulse circuit is a voltage at the grounding terminal.

When the controller inputs a low level to the base of the transistor Q, the collector and the emitter of the transistor are connected, and hence the emitter of the transistor Q can be regarded as directly connected to the power source HV In such case, a voltage at the emitter of the transistor Q is equal to the high voltage. Thereby, the voltage outputted by the pulse circuit switches between the high voltage and the grounding voltage, i.e., 0V, generating high-voltage pulses.

Embodiments shown in Figure 7 and Figure 8 are illustrated by taking an example that the high voltage is higher than the grounding voltage in electrical level. In practice, the high-voltage pulses outputted by the circuit for selecting ions may origin from the grounding voltage having a higher level and a negative high voltage (i.e., lower than the grounding voltage but greater in magnitude) having a lower level. In such case, the power source HV in Figure 7 and Figure 8 may be replaced with the grounding voltage, and the grounding terminal in Figure 7 and Figure 8 may be replaced with a voltage source outputting the negative high voltage.

In addition, the high-voltage pulses outputted by the circuit for selecting ions may origin from a high voltage having a higher level and a negative high voltage having a lower level. In such case, the grounding terminal in Figure 7 and Figure 8 may be replaced with a voltage source outputting the negative high voltage. It is appreciated that the circuit for selecting ions corresponding to this embodiment is applicable to an embodiment in which the deflection conductor is the focusing electrode 4 or the metal tubular shell 5.

Figure 8 is taken as an example. The transistor Q is switched off when the controller outputs the high level to the control terminal of the transistor Q, and is switched on when the controller outputs the low level to the control terminal of the transistor Q. The power source HV supplies a voltage ranging from tens of volts to one thousand volts, and is applied to the first terminal of the voltage divider R2 via the transistor Q. The voltage divider R2 may be a resistor having high voltage resistance with high power endurance. The node at which the voltage divider R2 and the transistor Q are connected is connected to the first terminal of the high-voltage capacitor C2. The second terminal of the high-voltage capacitor C2 is connected to the first terminal of the resistor R3 having high voltage resistance. The resistor R3 is an equivalent of a filter, and may also have high power endurance. Resistance of the resistor R3 is much less than that of the voltage divider R2. The second terminal of the high-voltage resistance R3 and the second terminal of the voltage divider R2 are grounded. A common terminal at which the voltage divider R2, the transistor Q, and the high-voltage capacitor C2 are connected serves as the output terminal of the circuit for selecting ions.

When the controller outputs the high level to the control terminal of the transistor Q, the transistor Q is switched on to form an electrical path. The power source HV is connected to the ground via the transistor Q and the voltage divider R2. A terminal at which the transistor Q, the voltage divider R2, and the high-voltage capacitor C2 are connected serves as the output terminal OUT of the circuit for selecting ions, and outputs the high voltage.

When the controller outputs the low level to the control terminal of the transistor Q, the transistor Q is switched off to open the electrical path. The output terminal of the circuit for selecting ions is grounded via the voltage divider R2 and outputs the low voltage. The RC series circuit formed by the capacitor C1 and the resistor R3 is capable to perform charging/discharging and filtering when a voltage changes in the high-voltage pulse signal, so that the outputted high-voltage pulse signal is subject to fast rises and falls having a scale of several nanoseconds. Precision of switching between the high voltage and the low voltage is ensured in the high-voltage pulse signal.

As mentioned above, the controller switches the transistor between on and off by outputting the low-voltage pulse signal, and thereby control the high-voltage pulse signal outputted by the circuit for selecting ions. That is, herein the outputted high-voltage pulses are controlled through the low-voltage pulses outputted by the controller. In order to ensure safety of the circuit, an isolation circuit is further provided between the controller and the control terminal of the transistor. In a specific embodiment, an isolation chip may be connected between the controller and RC parallel circuit to avoid interference of the high-voltage pulses on the controller.

Herein the high-voltage pulse circuit refers to a circuit configured to output a square -wave pulse signal switching between a high voltage and a low voltage, and there is a large voltage difference between the high voltage and the low voltage. Theoretically, the switching between the high voltage and the low voltage is implemented instantaneously at rising edges and at falling edges. In practice, such instantaneous switching is hard to achieve, and the rising edges and the falling edges are subject to certain delays. The larger the voltage difference between the high voltage and the low voltage is, the longer the delay is.

Therefore, a high-voltage pulse circuit is provided according to an embodiment of the present disclosure. The delays at the rising edge and the falling edge are shorted in the outputted high-voltage pulses having a large voltage difference between the high voltage and the low voltage.

For better understanding of those skilled in the art, hereinafter technical solutions in embodiments of the present disclosure are described clearly and completely in conjunction with the drawings in embodiments of the present closure. Apparently, the described embodiments are only some rather than all of the embodiments of the present disclosure. Any other embodiments obtained based on the embodiments of the present disclosure by those skilled in the art without any creative effort fall within the scope of protection of the present disclosure.

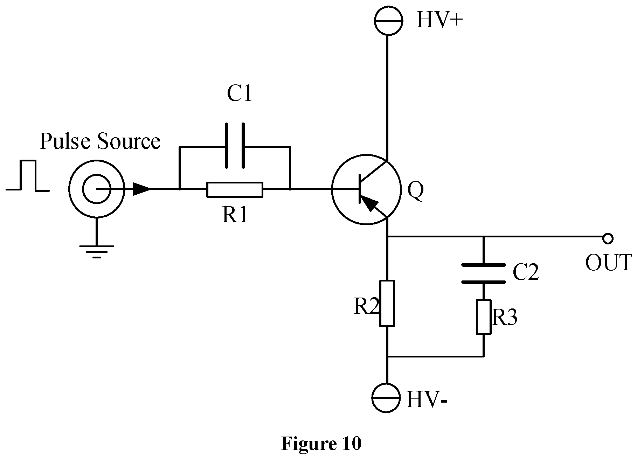

Reference is made to Figure 9 and Figure 10. Figure 9 is a schematic structural diagram of a high-voltage pulse circuit according to an embodiment of the present disclosure. Figure 10 is a schematic structural diagram of a high-voltage pulse circuit according to another embodiment of the present disclosure. The high-voltage pulse circuit comprises a first voltage source HV+ and a second voltage source HV-. Since there is the large voltage difference between the high voltage and the low voltage outputted by the high-voltage pulse circuit, herein a difference between a voltage outputted by the first voltage source HV+ and a voltage outputted by the second voltage source HV- is not less than a preset voltage. That is, there is also a large voltage difference between the voltage outputted by the first voltage source HV+ and the voltage outputted by the second voltage source HV-. Specific amplitude of such voltage difference is proportional to the required voltage difference between the high voltage and the low voltage in the high-voltage pulse signal outputted by the high-voltage pulse circuit.

In an embodiment, the first voltage source HV+ is a power source which outputs a high voltage, and the second voltage source HV- outputs a grounding voltage. Alternatively, the first voltage source HV+ is a power source which outputs a high voltage, and the second voltage source HV- is a power source outputs a negative high voltage. Alternatively, the first voltage source HV+ outputs a grounding voltage, and the second voltage source HV- is a power source outputs a negative high voltage.

Herein the high voltage may refer to a voltage ranging from tens of volts to one thousand volts. Similarly, the negative high voltage may refer to a negative voltage having amplitude ranging from tens of volts to one thousand volts.

The high-voltage pulse circuit may further comprise a pulse circuit and an RC series circuit.

The pulse circuit comprises a voltage divider R2 and a transistor Q that are connected in series.

A terminal of the pulse circuit is connected to the first voltage source HV+, and another terminal of the pulse circuit is connected to the second voltage source HV-. A node at which the voltage divider R2 and the transistor Q are connected serves as an output terminal OUT of the high-voltage pulse circuit. A control terminal of the transistor Q is configured to receive a switch controlling signal, and the transistor Q is switched between on and off according to the switch controlling signal.

A first terminal of the RC series circuit is connected to the output terminal OUT of the high-voltage pulse circuit, and a second terminal of the RC series circuit is connected to the second voltage source HV-.

In an embodiment, the control terminal of the transistor Q may be connected in series with an RC parallel circuit. That is, a first terminal of the RC parallel circuit is configured to receive the switch controlling signal, and a second terminal of the RC parallel circuit is connected to the control terminal of the transistor Q. The switch controlling signal is used for switching the transistor Q between on and off.

As shown in Figure 9 and Figure 10, the RC parallel circuit may comprise the resistor R1 and the capacitor C1 which are connected in parallel.

The voltage divider R2 in the pulse circuit may be a voltage dividing resistor or another circuit component having a certain resistance. The transistor Q may be a semiconductor switching device such as a MOS transistor.

The pulse circuit is a series branch connected between the first voltage source HV+ and the second voltage source HV-, and serves as a main circuit for outputting high-voltage pulses. Moreover, the voltage divider R2 and the transistor Q in the pulse circuit may be connected in series between the first voltage source HV+ and the second voltage source HV- in two different configurations.

Reference is made to Figure 9. In an optional embodiment, a first terminal of the voltage divider R2 is connected to the first voltage source, a second terminal of the voltage divider R2 is connected to the first terminal of the transistor Q, and a second terminal of the transistor Q is connected to the second voltage source. The control terminal of the transistor Q is connected to the second terminal of the RC parallel circuit.

The control terminal of the transistor Q in the pulse circuit receives the switch controlling signal via the RC parallel circuit. The switch controlling signal may be a low-voltage pulse signal generated by the controller or another pulse source. As shown in Figure 9, it is taken as an example that the first voltage source HV+ is a high-voltage power source, the second voltage source HV- outputs the grounding voltage, and the transistor Q is an NPN transistor. The control terminal of the transistor Q is a base of NPN transistor, the first terminal of the transistor Q is a collector of the NPN transistor, and the second terminal of the transistor Q is an emitter of the NPN transistor.

When the control terminal of the transistor Q receives a low level, the first terminal and the second terminal of the transistor Q are electrically disconnected from each other. The voltage divider R2 connected to the first terminal of the transistor Q is electrically disconnected from the second voltage source HV- connected to the second terminal of the transistor Q. In such case, the first terminal of the voltage divider R2 can be regarded as connected to the high-voltage power source, and the second terminal of the voltage divider R2 serves as the output terminal of the high-voltage pulse circuit. It is appreciated that a voltage at the second terminal of the voltage divider R2 is the voltage outputted by the high-voltage power source, that is, a high voltage is outputted.

When the control terminal of the transistor Q receives a high level, the first terminal and the second terminal of the transistor Q are electrically connected to each other. The voltage divider R2 connected to the first terminal of the transistor Q is electrically connected to the second voltage source connected to the second terminal of the transistor Q. In such case, the first terminal of the voltage divider R2 is connected to the first voltage source HV+, the second terminal of the voltage divider R2 is connected to the second voltage source HV-, and the second terminal of the voltage divider R2 serves as the output terminal of the high-voltage pulse circuit. It is appreciated that a voltage at the second terminal of the voltage divider R2 is equal to a voltage outputted by the second voltage source HV-. The second voltage source HV- is the grounding voltage, and consequently, the voltage outputted from the output terminal of the high-voltage pulse circuit is the grounding voltage, i.e., 0V

Thereby, when the controlling signal switches between the high level and the low level, the voltage outputted by the high-voltage pulse circuit switches between the first voltage outputted by the first voltage source and the second voltage outputted by the second voltage source, generating high-voltage pulses.

Reference is made to Figure 10. In another optional embodiment, a first terminal of the transistor Q is connected to the first voltage source HV-, a second terminal of the transistor Q is connected to a first terminal of the voltage divider R2, a control terminal of the transistor Q is connected to the second terminal of the RC parallel circuit, and a second terminal of the voltage divider R2 is connected to the second voltage source.

As illustrated in Figure 10, it is taken as an example that the first voltage source HV+ is a high-voltage power source, the second voltage source HV- outputs a grounding voltage, and the transistor Q is a PNP transistor. Similarly, the control terminal of the transistor Q is the base of the PNP transistor, the first terminal of the transistor Q is the collector of the PNP transistor, and the second terminal of the transistor Q is the emitter of the PNP transistor. Similar to operation principles of the circuit configuration as shown in Figure 9, the first terminal and the second terminal of the transistor Q are electrically disconnected from each other when the switch controlling signal is the high level, and the first terminal and the second terminal of the transistor Q are electrically connected to each other when the switch controlling signal is the low level.

In both embodiments as shown in Figure 9 and Figure 10, the pulse circuit is a series branch connected between the first voltage source HV+ and the second voltage source HV-, which is main part of the high-voltage pulse circuit for outputting the high-voltage pulses. The voltage outputted from the output terminal OUT of the high-voltage pulse circuit is the voltage at the node at which the transistor Q and the voltage divider R2 are connected in the pulse circuit.

Moreover, regardless a sequence of the voltage divider R2 and the transistor Q in the series branch, the pulse circuit connected between the first voltage source HV+ and the second voltage source HV- can be regarded as an RC series circuit formed by the voltage divider R2 and the transistor Q. A junction capacitor of the transistor Q introduces a delay when the transistor Q is switched between on and off, and hence results in delays at rising edges and falling edges of the finally outputted high-voltage pulses.

In order to reduce the delays of the rising edges and the falling edges when the circuit for selecting ions switches between the high voltage and the low voltage, another RC series circuit may be provided as a parallel branch connected between the output terminal OUT and the second power supply HV- in the circuit for selecting ions.

The RC series circuit may comprise a capacitor C2 and a resistor R3 which are connected in series and have high-voltage resistance. The resistor R3 is subject to large power, and resistance of the resistor R3 is required to be less than that of the voltage divider. The RC series circuit formed by the high-voltage capacitor C2 and the high-voltage resistor R3 forms a path of charging/discharging and performs filtering when a voltage changes in the high-voltage pulse signal. The capacitor C2 in the RC series circuit charges the transistor Q when the transistor Q is switched on, and discharges the transistor Q when the transistor Q is switched off. Hence, the delays at the rising edges and the falling edges in the outputted high-voltage pulse signal are shortened, which achieves rapid switch between the high voltage and the low voltage in the outputted high-voltage pulse signal. The rises and falls in the outputted high-voltage pulse signal can be implemented in extremely short time, which has an order of several nanoseconds. Thereby, switching between the high voltage and the low voltage in the high-voltage pulse signal is more precise. Moreover, the RC circuit is capable of filtering, which removes high-order harmonics and hence regularizes a waveform of the high-voltage pulse signal.

In addition, the switch controlling signal is further inputted to the control terminal of the transistor Q via an RC parallel circuit. Due to a charging/discharging function of a capacitor C1 in the RC parallel circuit, time required for switching the transistor Q between on and off according to switch controlling signal is shortened.

In the foregoing high-voltage pulse signal outputted by the high-voltage pulse circuit, delays at the rising edges and the falling edges can be shortened to a scale of several nanometers. The delays are greatly reduced, and hence the high-voltage pulse circuit can improve control precision of various control systems when applied to these systems.

In summary, herein the high-voltage pulse circuit utilizes the voltage divider and the transistor which are connected in series between two voltage sources, and there is the large difference between the voltages supplied by the two voltage sources. The transistor is switched between on and off under control of the switch controlling signal, which is inputted to the control terminal of the receiving transistor. The outputted high-voltage pulse signal switches between the high voltage and the low voltage according to the switch controlling signals switching between different levels. The RC parallel circuit is further connected to the control terminal of the transistor, such that the delays at the rising edges and the falling edges is greatly reduced during switching between the high voltage and the low voltage. Wide application of the high-voltage pulse signal is facilitated, and the control precision of the high-voltage pulse circuit applied in various devices is improved.

On a basis of the above embodiment, the foregoing high-voltage pulse circuit is applied to a mass spectrometer to select between target ions and non-target ions according to an embodiment of the present disclosure. A circuit for selecting ions is further provided according to a specific embodiment of the present disclosure. The circuit for selecting ions is applied to a mass spectrometer in which a conductor for deflecting non-target ions is arranged. The circuit for selecting ions comprises a controller and any foregoing high-voltage pulse circuit. The output terminal of the high-voltage pulse circuit is connected to the conductor. An output terminal of the controller is connected to the control terminal of the transistor in the high-voltage pulse circuit. The controller is configured to output the switch controlling signal, and switch the switch controlling signal between two different levels, such that a high-voltage pulse signal outputted by the high-voltage pulse circuit switches between two different voltages.

Reference is made to foregoing embodiments of the high-voltage pulse circuit. The switch controlling signal which is outputted by the controller and switched between two different levels is the switch controlling signal which has two different states and is inputted to the control terminal of the transistor in the high-voltage pulse circuit. It is taken as an example that the switch controlling signal outputted by the controller is a low-voltage pulse signal. The switch controlling signal having two different levels may be a low-voltage pulse signal having a low level and a high level. When the controller outputs one level to the high-voltage pulse circuit, the high-voltage pulse circuit outputs a corresponding voltage in the pulse signal. For example, the high-voltage pulse circuit outputs the high voltage of the high-voltage pulse signal when the controller feeds the low level to the control terminal of the transistor in the high-voltage pulse circuit, and outputs the low voltage of the high-voltage pulse signal when the controller inputs the high level to the control terminal of the transistor in the high-voltage pulse circuit. That is, a voltage applied by the high-voltage pulse circuit applies to the conductor enables the conductor to generate an electric field deflecting the non-target ions when the controller outputs one level of the switch controlling signals, and disables the conductor of generating such electric field when the controller outputs another level of the switch controlling signal.

When the controller outputs high and low levels of the switch controlling signal, an operation of the high-voltage pulse circuit outputting corresponding voltages in the high-voltage pulse signal may refer to the foregoing embodiments of the high-voltage pulse circuit, and details are not repeated herein.

In an optional embodiment, the controller is connected to the pulse circuit via an isolation circuit.

Reference is made to Figure 3, which is a schematic structural diagram showing a cross-section of a mass spectrometer according to an embodiment of the present disclosure. In a mass spectrometer, a pulsed laser emitted by a laser source 2a excites a sample 01, which is a source of ions, to generate ions having different molecular weights. The ions with different molecular weights are accelerated to different speeds in an acceleration electric field U. Ions with a smaller molecular weight are accelerated to a greater speed, and hence leave the acceleration electric field U and enter a field-free region earlier when flying toward a detector 1. Ions with a larger molecular weight are accelerated to a smaller speed, and hence leave the acceleration electric field U and enter the field-free region later when flying toward a detector 1.

Generally, during actual ion detection, only target ions having the molecular weight within a specific range are required to be detected, and ions having other molecular weights are called non-target ions. The non-target ions, which reach and are detected by the detector 1, not only shorten a service life of the detector 1 but also blur a result of detecting the target ions.

The difference in mass between the target ions and the non-target ions leads to the different in time at which the target ions and the non-target ions pass the field-free region, which is utilized herein for selection between the target ions and non-target ions. A conductor is provided in a field-free region of the mass spectrometer. Different electrical signals are applied when the target ions pass the field-free region and when the non-target ions pass the field-free region. Hence, the conductor generates different electric fields when the target ions pass the field-free region and when the non-target ions pass the field-free region. When the target ions is close to the conductor, a flight direction of the target ions does not change, and the target ions continue to fly towards the detector. When non-target ions are close to the conductor, the non-target ions are deflected under the electric field generated by the conductor, and thus cannot reach the detector. Thereby, selection is made between the target ions and the non-target ions.

For example, the conductor comprises the first conductor plate 31 and the second conductor plate 32, and the first conductor plate 31 and the second conductor plate 32 are arranged on two sides, respectively, of the ion-flight path. The first conductor plate 31 is grounded, and the second conductor plate 32 is connected to the output terminal of the circuit for selecting ions.

When the target ions fly through the field-free region, the controller may control the circuit for selecting ions to output a grounding voltage. In such case, there is no electric field between the first conductor plate 31 and the second conductor plate 32, and the target ions can pass the field-free region without interference and reach the detector 1.

When the non-target ions fly through the field-free region, the controller may control the high-voltage pulse circuit to output a high voltage. In such case, an electric field is generated between the first conductor plate 31 and the second conductor plate 32, and a direction of the electric field is perpendicular to a flight direction of the non-target ions. As a result, when flying through the electric field, the non-target ions are deflected and cannot reach the detector 1. Thereby, selection is made between the target ions and the non-target ions.

In practice, it is not necessary that the conductor is two conductor plates, and may be implemented as a metal tube. Ions fly through the metal tube along a direction parallel to a central axis of the metal tube. In such case, the first voltage source HV+ in the high-voltage pulse circuit may be a voltage source outputting a high voltage, and the second voltage source HV+ in the high-voltage pulse circuit may be a voltage source outputting a negative high voltage. The high voltage and the negative high voltage may induce the high voltage the low voltage, respectively, which are outputted by the high-voltage pulse circuit.

Positive ions are taken as an example. When the target ions fly through the metal tube, the controller controls the high-voltage pulse circuit to apply the high voltage to the metal tube, so that the electric field inside the metal tube adjust a trajectory of the flying target ions to converge toward the central axis of the metal tube, and hence the target ions can reach the detector 1. When the non-target ions fly through the metal tube, the controller controls the high-voltage pulse circuit to apply the low voltage to the metal tube, so that the electric field inside the metal tube deflects the trajectory of the non-target ions toward a wall of the metal tube, and hence the non-target ions cannot reach the detector. Thereby, selection is made between the target ions and the non-target ions. In case of negative ions, the low voltage is applied to the metal tube when the target ions fly through the metal tube, and the high voltage is applied to the metal tube when the non-target ions fly through the metal tube.

The target ions and the non-target ions pass through the field-free region at different time, and a specific sequence depends on molecular weights of the target ions and the non-target ions. There is little difference between a time instant at which the target ions pass the field-free region and a time instant between a time instant at which the non-target ions pass the field-free region, and therefore rapid switch between the two different voltages applied to the conductor are necessary. Herein the high-voltage pulse circuit can greatly shorten the delay at switching between the high voltage and the low voltage, thereby meeting the requirement on the short delay at switching between the two voltages for selecting between the target ions and the non-target ions. The precision of selecting ions in the mass spectrometer is improved. Thereby, the service life of the detector is prolonged, and a result of the detection is cleared when presented.

It should be noted that, the relationship terms such as "first", "second" and the like are only used herein to distinguish one entity or operation from another, rather than to necessitate or imply that an actual relationship or order exists between the entities or operations. Furthermore, the terms such as "include", "comprise" or any other variants thereof means to be non-exclusive, and hence inclusion of a series of inherent elements of the process, the method, the article or the device is also indicated. Unless expressively limited, the statement "including a..." does not exclude the case that other similar elements may exist in the process, the method, the article or the device other than enumerated elements. Moreover, the foregoing technical solutions provided herein may have parts which are consistent with implementation principles in conventional technical solutions, and these parts are not described in detail for conciseness.

Herein the principle and embodiments of the present disclosure are described through specific examples. The description of the above-described embodiments is merely intended for helping understand the method and key concept of the present disclosure. Those skilled in the art can made several improvements and modifications on a basis of the present disclosure without departing from the principle of the present disclosure. These improvements and modifications also fall within the protection scope of claims of the present disclosure.

## Claims

1. A method for selecting ions in a mass spectrometer, wherein a deflection conductor is disposed at a side of an ion-flight path between an acceleration electric field and a detector in the mass spectrometer, and the method comprises:
applying a first voltage to the deflection conductor to generate a deflection electric field at the deflection conductor, wherein ions are deflected to a trajectory not reaching the detector when flying through the deflection electric field;
maintaining the first voltage applied to the deflection conductor to deflect non-target ions, among the ions, which fly out of the acceleration electric field, in response to detecting that a pulse synchronized with a laser is outputted;
applying a second voltage to the deflection conductor to stop generating the deflection electric field and enable target ions, among the ions, to reach the detector, in response to the target ions flying out of the acceleration electric field; and
applying the first voltage to the deflection conductor, in response to all of the target ions flying past the deflection conductor;
wherein the deflection conductor comprises at least one pair of conductor plates arranged at two sides of the ion-flight path, each of the at least one pair of conductor plates comprises a first conductor plate and a second conductor plate, and the first conductor plate is grounded;
wherein applying the first voltage to the deflection conductor comprises:
applying a high voltage which is greater than a grounding voltage to the second conductor to the second conductor plate, or
applying a negative high voltage which is lower than a grounding voltage to the second conductor plate; and
wherein applying the second voltage to the deflection conductor comprises:
applying a voltage equal to the grounding voltage to the second conductor plate.

2. The method according to claim 1, wherein:
the deflection conductor is a focusing electrode arranged in the mass spectrometer or a metal tubular shell arranged in a field-free region of the mass spectrometer;
applying the first voltage to the deflection conductor comprises:
applying a high voltage, which is opposite to the ions in electrical polarity, to the deflection conductor; and
applying the second voltage to the deflection conductor comprises:
applying a high voltage, which is identical the ions in electrical polarity, to the deflection conductor.

3. The method according to claim 1 or 2, further comprising:
applying the first voltage and the second voltage alternately to the deflection conductor for a plurality of cycles,
wherein in each of the plurality of cycles, duration of applying the first voltage and duration of applying the second voltage is determined by a molecular weight of the non-target ions that are to be deflected and a molecular weight of the target ions that are not to be deflected.

4. A system for selecting ions in a mass spectrometer, comprising:
a controller, of which an input terminal is connected to a laser source configured to output a laser pulse; and
a circuit for selecting ions, wherein an output terminal of the circuit is connected to a deflection conductor disposed in the mass spectrometer, and an input terminal of the circuit is connected to the controller;
wherein the controller is configured to control the circuit for selecting ions to output a voltage, which is switched between a first voltage and a second voltage, to the deflection conductor to implement any forgoing method for selecting ions in the mass spectrometer.

5. The system according to claim 4, wherein:
the deflection conductor is at least one pair of conductor plates arranged at two sides of the ion-flight path, each of the at least one pair of conductor plates comprises a first conductor plate and a second conductor plate, and the first conductor plate is grounded;
the second conductor plate is connected to an output terminal of the circuit for selecting ions, and the circuit for selecting ions comprises a high-voltage power source, a pulse circuit, and an RC series circuit;
the pulse circuit comprises a voltage divider and a transistor that are connected in series;
a terminal of the pulse circuit is connected to an output terminal of the high-voltage power source, and another terminal of the pulse circuit is grounded;
a node at which the voltage divider and the transistor are connected serves as the output terminal of the circuit for selecting ions;
a first terminal of the RC series circuit is connected to the output terminal of the circuit for selecting ions, and a second terminal of the RC series circuit is grounded; and
the controller is connected to the control terminal of the transistor, and the controller is configured to switch the transistor between on and off.

6. The system according to claim 5, wherein:
a first terminal of the voltage divider is connected to the high-voltage power source, a second terminal of the voltage divider is connected to a first terminal of the transistor, and a second terminal of the transistor is grounded;
the first terminal and the second terminal of the transistor are electrically disconnected, in response to the controller outputting an electrical level,; and
the first terminal and the second terminal of the transistor are electrically connected, in response to the controller outputting another electrical level higher that the electrical level.

7. The system according to claim 5, wherein:
a first terminal of the transistor is connected to the high-voltage power source, a second terminal of the transistor is connected to a first terminal of the voltage divider, and a second terminal of the voltage divider is grounded;
the first terminal and the second terminal of the transistor are electrically disconnected, in response to the controller outputting an electrical level; and
the first terminal and the second terminal of the transistor are electrically connected, in response to the controller outputting another electrical level higher that the electrical level.

8. The system according to claim 5, wherein the circuit for selecting ions further comprises an RC parallel circuit, and the control terminal of the transistor is connected to the controller via the RC parallel circuit.

9. A high-voltage pulse circuit, comprising a first voltage source, a second voltage source, a pulse circuit, and an RC series circuit, wherein:
a difference between a voltage outputted by the first voltage source and a voltage outputted by the second voltage source is not less than a preset voltage;
the pulse circuit comprises a voltage divider and a transistor that are connected in series;
a terminal of the pulse circuit is connected to the first voltage source, and another terminal of the pulse circuit is connected to the second voltage source;
a node at which the voltage divider and the transistor are connected serves as an output terminal of the high-voltage pulse circuit;
a first terminal of the RC series circuit is connected to the output terminal of the high-voltage pulse circuit, and a second terminal of the RC series circuit is connected to the second voltage source; and
the transistor is configured to switch between on and off according to a switch controlling signal received by a control terminal of the transistor.

10. The high-voltage pulse circuit according to claim 9, wherein:
a first terminal of the voltage divider is connected to the first voltage source, a second terminal of the voltage divider is connected to a first terminal of the transistor, and a second terminal of the transistor is connected to the second voltage source; and
the first terminal and the second terminal of the transistor are electrically connected in response to the switch controlling signal is at an electrical level, and are electrically disconnected in response to the switch controlling signal is at another electrical level lower than the electrical level.

11. The high-voltage pulse circuit according to claim 9, wherein:
a first terminal of the transistor is connected to the first voltage source, a second terminal of the transistor is connected to a first terminal of the voltage divider, and a second terminal of the voltage divider is connected to the second voltage source; and
the first terminal and the second terminal of the transistor are electrically connected in response to the switch controlling signal is at an electrical level, and are electrically disconnected in response to the switch controlling signal is at another electrical level lower than the electrical level.

12. The high-voltage pulse circuit according to claim 9, wherein:
the first voltage source is a power source that outputs a high voltage, and the voltage outputted by the second voltage source is a grounding voltage;
the first voltage source is a power source that outputs a high voltage, and the second voltage source is a power source that outputs a negative high voltage; or
the voltage outputted by the first voltage source is a grounding voltage, and the second voltage source is a power source that outputs a negative high voltage.

13. The high-voltage pulse circuit according to any one of claims 9 to 12, further comprising an RC parallel circuit connected to the control terminal of the transistor, wherein the control terminal of the transistor is configured to receive the switch controlling signal via the RC parallel circuit.

14. A circuit for selecting ions, applicable to a mass spectrometer comprising a conductor for deflecting non-target ions, wherein the circuit comprises:
a controller; and
the high-voltage pulse circuit according to any one of claims 9 to 13;
wherein the output terminal of the high-voltage pulse circuit is connected to the conductor, and an output terminal of the controller is connected to the control terminal of the transistor in the high-voltage pulse circuit; and
wherein the controller is configured to output the switch controlling signal to the high-voltage pulse circuit, and switch the switch controlling signal between two different levels to enable a high-voltage pulse signal outputted by the high-voltage pulse circuit to switch between two different voltages.
